# EUROPÄISCHE PATENTSCHRIFT

(11) **EP 3 913 807 B1**
(45) Veröffentlichungstag und Bekanntmachung des Hinweises auf die Patenterteilung: **06.05.2026**
(21) Anmeldenummer: 21162076.0
(22) Anmeldetag: 11.03.2021
(51) Int. Cl.: H03K 17/95, H03K 17/955, A01D 41/127, G01F 1/64, G01F 1/66, G01N 27/22, G01F 23/284

(54) **MÄHDRESCHER MIT EINEM SENSORSYSTEM**
COMBINE HARVESTER WITH A SENSOR SYSTEM
MOISSONNEUSE-BATTEUSE DOTÉE D'UN SYSTÈME DE CAPTEUR

(30) Priorität: 20.05.2020 DE 102020113667
(43) Veröffentlichungstag der Anmeldung: 24.11.2021
(73) Patentinhaber: CLAAS Selbstfahrende Erntemaschinen GmbH, 33428 Harsewinkel (DE)
(72) Erfinder: Neitemeier, Dennis, 59510 Lippetal (DE); Baumgarten, Joachim, 48361 Beelen (DE); Wilken, Andreas, 49143 Bissendorf (DE); Bormann, Bastian, 33334 Gütersloh (DE); Witte, Johann, 58730 Fröndenberg (DE)
(74) Vertreter: CLAAS Gruppe

(56) Entgegenhaltungen:
- DE-A1- 19 934 881
- GB-A- 2 296 972
- JP-A- H09 159 500
- JP-A- H09 257 535
- US-A- 6 121 782
- US-B2- 6 700 392

## Beschreibung

Die Erfindung betrifft einen Mähdrescher mit einem siebartigen Element und einem Sensorsystem.

Aus der EP3222133A1 Verfahren zum Erfassen einer Kornzahl eines Erntegutstromes bekannt. Dabei werden Körner, die auf eine Prallfläche des Sensors aufprallen, mittels eines Messsignals erfasst. Der Sensor ist dabei nicht in der Lage zu erkennen, was für Elemente auf die Prallfläche des Sensors aufprallen.

Aus der EP3301407A1 ist ein Verfahren zur Bestimmung eines Massenstromes bekannt. Dabei wird Kraft gemessen, die ein Massenstrom auf einen Sensor ausübt. Der Sensor ist dabei nicht in der Lage zu erkennen, was für Elemente die Kraft ausüben. Weitere bekannte Mähdrescher mit einem siebartigen Element und Sensorsystemen sind in DE19934881A1, US6121782A und US6700392B2 offenbart.

Aufgabe der Erfindung ist es einen Sensor bereitzustellen, der mehr Informationen über die erfassten Elemente liefert.

Die Aufgabe wird gelöst durch ein Sensorsystem zur Erfassung von Elementen eines Erntegutstromes, insbesondere in einer landwirtschaftlichen Arbeitsmaschine, wobei das Sensorsystem einen Schwingkreis und eine Messeinrichtung umfasst, wobei der Schwingkreis aus zumindest einem kapazitiven Bauelement mit einer Kapazität und einem induktiven Bauelement mit einer Induktivität besteht, wobei der Schwingkreis eine Resonanzfrequenz aufweist, wobei die Resonanzfrequenz von der Kapazität und der Induktivität abhängt, wobei die Messeinrichtung zur Bestimmung der Resonanzfrequenz des Schwingkreises vorgesehen und eingerichtet ist, wobei das kapazitive Bauelement im Bereich des Erntegutstromes angeordnet ist, wobei das kapazitive Bauelemente dazu eingerichtet ist, dass die Kapazität durch einzelne Elemente des Erntegutstromes beeinflusst wird, wobei das Sensorsystem dazu vorgesehen und eingerichtet ist aus der Resonanzfrequenz des Schwingkreises auf zumindest eine Eigenschaft des jeweiligen Elementes des Erntegutstromes zu schließen.

Das Sensorsystem misst die Auswirkung des Elementes des Erntegutstromes auf die Kapazität des kapazitiven Bauelementes. Durch die Änderung der Kapazität wird die Resonanzfrequenz des Schwingkreises verändert. Die Änderung der Resonanzfrequenz bzw. der Kapazität kann gemessen werden und damit das Element des Erntegutstromes erfasst werden. Die erfassten Elemente des Erntegutstromes können gezählt werden.

Das induktive Bauelement kann in die Messeinrichtung integriert sein, bspw. in Form eines integrierten Schaltkreises. Bei bekannter Induktivität kann aus der Resonanzfrequenz direkt auf die Kapazität geschlossen werden. Anstelle der Änderung der Resonanzfrequenz kann daher auch die Änderung der Kapazität bestimmt werden.

Die Stärke der Änderung der Kapazität und der Resonanzfrequenz hängt von der Permittivität des Elementes des Erntegutstromes ab. Mit der Bestimmung der Resonanzfrequenz ist das Sensorsystem in der Lage auf die Permittivität des Elementes zu schließen. Die Permittivität wird auch Permittivitäts- oder Dielektrizitätszahl genannt.

Das Sensorsystem ist bevorzugt dazu vorgesehen und eingerichtet ist zwischen Kornelementen und Nichtkornelementen, insbesondere Strohelementen, zu unterscheiden. Kornelemente besitzen eine wesentlich größere Permittivität als Strohelemente. Ein Kornelement ändert daher die Resonanzfrequenz stärker als ein Strohelement. Die zu unterscheidende Eigenschaft der Elemente des Erntegutstromes ist in diesem Fall ob das jeweilige Element ein Kornelement oder ein Strohelement ist.

Die Messeinrichtung bestimmt die Resonanzfrequenz bevorzugt mit einer vorbestimmten Messfrequenz. Durch die regelmäßige Bestimmung der Resonanzfrequenz wird der zeitliche Verlauf der Messung von Elementen des Erntegutstromes durch das Sensorsystem bestimmt.

Die Resonanzfrequenz ist bevorzugt größer ist als 1kHz. Je höher die Resonanzfrequenz ist, umso schneller kann sie genau vermessen werden.

Die Messfrequenz ist bevorzugt kleiner als ein Zehntel der Resonanzfrequenz. Durch die im Verhältnis zur Resonanzfrequenz kleine Messfrequenz können in jeder Messung mindestens zehn Perioden der Schwingungen des Schwingkreises zur Bestimmung der Resonanzfrequenz vermessen werden. Dadurch wird die Bestimmung der Resonanzfrequenz genauer als wenn nur wenige Perioden vermessen werden.

Die Messfrequenz multipliziert mit der Länge des kapazitiven Bauelementes in Bewegungsrichtung des Erntegutstromes ist bevorzugt größer ist als 2m/s, besonders bevorzugt größer als 30m/s, ganz besonders bevorzugt größer als 40m/s. Die Messfrequenz multipliziert mit der Länge des kapazitiven Bauelementes Bewegungsrichtung des Erntegutstromes gibt die Bewegungsgeschwindigkeit der Elemente des Erntegutstromes an, die noch mit Sicherheit von dem Sensorsystem erfasst werden. Bei einer Bewegungsgeschwindigkeit von 2m/s lassen sich Körner sicher erfassen, die vom Spelz getrennt lediglich von der Erdanziehungskraft beschleunigt werden. Dies ist bspw. in einem Mähdrescher am Schüttler oder am Reinigungssieb der Fall. Bei einer Bewegungsgeschwindigkeit von 10m/s lassen sich Körner sicher erfassen, die im Mähdrescher von der Dreschtrommel oder einem Rotor beschleunigt wurde. Bei einer Bewegungsgeschwindigkeit von 25m/s lassen sich Körner sicher erfassen, die in einem Feldhäcksler zum Auswurf beschleunigt wurden.

Von der Messfrequenz zu unterscheiden ist die Abtastfrequenz. Die Abtastfrequenz gibt an wie oft eine Spannung und/oder ein Strom im Schwingkreis bestimmt wird. Die Abtastfrequenz ist mindestens doppelt so groß wie die vom Schwingkreis erwartete Resonanzfrequenz. Bevorzugt ist die Abtastfrequenz zehnmal so groß wie die vom Schwingkreis erwartete Resonanzfrequenz.

Das kapazitive Bauelement ist als planarer Kondensator ausgebildet. Die Kapazität eines planaren Kondensators wird durch Elemente in der direkten Nähe seiner Oberfläche beeinflusst. Ein planarer Kondensator kann am Rand des Erntegutstromes montiert werden und detektiert die an ihm vorbeifließenden Elemente des Erntegutstromes. Ein planarer Kodensator stört den Erntegutstrom weniger als ein Plattenkondensator mit zwei Platten.

Das kapazitive Bauelement ist als Interdigitalkondensator ausgestaltet. Ein Interdigitalkondensator weißt über seine Oberfläche eine gleichmäßige Sensitivität für Elemente aus dem Erntegutstrom auf. Ein Element beeinflusst die Resonanzfrequenz also in gleichem Maße unabhängig von seiner Position.

Das Sensorsystem ist in einem Mähdrescher verbaut. Die Erfindung betrifft einen Mähdrescher mit einem siebartigen Element und einem Sensorsystem, wobei das Sensorsystem einen Schwingkreis und einer Messeinrichtung umfasst, wobei der Schwingkreis zumindest ein kapazitives Bauelement mit einer Kapazität und ein induktives Bauelement umfasst,
wobei das kapazitive Bauelement in unmittelbarer Nähe des siebartigen Elementes angebracht ist, wobei das siebartige Element durchlaufende Elemente eines Erntegutstromes das kapazitive Bauelement passieren und zumindest temporär die Kapazität des kapazitiven Bauelementes verändern, wobei die Messeinrichtung zur Bestimmung der Resonanzfrequenz des Schwingkreises vorgesehen und eingerichtet ist, wobei das Sensorystem dazu vorgesehen und eingerichtet ist aus der Resonanzfrequenz des Schwingkreises auf zumindest eine Eigenschaft des jeweiligen Elementes des Erntegutstromes zu schließen.

Das Sensorsystem zählt in diesem Fall durch den Mähdrescher fließende Elemente des Erntegutstromes.

Das kapazitive Element ist in Bewegungsrichtung des Erntegutstromes hinter dem siebartigen Element angeordnet. Das Sensorsystem zählt damit nur die durch das siebartige Element hindurchtretenden Elemente des Erntegutstromes. Elemente des Erntegutstromes, die an dem siebartigen Element vorbei fließen werden nicht gezählt.

Das siebartige Element ist bevorzugt ein Dreschkorb, eine Klappenmatrix unter einem Rotor, ein Schüttler oder ein Reinigungssieb. Ein siebartiges Element zeichnet sich durch eine Gitterstruktur aus. Die Größe der Öffnungen ist dabei variabel und kann von Element zu Element variieren und ggf. verstellbar sein. So sind die Öffnungen eines Reinigungssiebes in ihrer Größe verstellbar und werden meist auf eine Größe eingestellt, die kaum größer ist als die Körner, welche geerntet werden sollen. Die Öffnungen eines Dreschkorbes hingegen sind typischerweise von fester Größe und wesentlich größer als die Körner.

Die Oberflächennormale des planaren Kondensators ist bevorzug im Wesentlichen senkrecht zur Bewegungsrichtung des Erntegutstromes ausgerichtet. Die Elemente des Erntegutstromes bewegen sich dadurch im Wesentlichen entlang der Oberfläche des Kondensators. Diese Anordnung kombiniert eine möglichst geringe Störung des Erntegutstromes mit einer guten Zählung der Elemente des Erntegutstromes.

Das kapazitive Bauelement ist bevorzugt auf einer Oberfläche des siebartigen Elementes angebracht. Direkt auf der Oberfläche des siebartigen Elementes aufgebracht ist die Störung des Erntegutstromes minimal.

Die Erfindung wird nachstehend anhand eines Ausführungsbeispiels näher erläutert. Die Figuren zeigen in
- Fig. 1:: einen Mähdrescher mit Hordenschüttler,
- Fig. 2:: einen Mähdrescher mit einem Trennrotor,
- Fig. 3:: einen Rotor eines Axialabscheiders
- Fig. 4:: ein Schema eines Sensorsystems zur Erfassung von Elementes eines Erntegutstromes,
- Fig. 5:: einen Interdigitalkondensator. Fig. 6. zeigt eine Siebebene des Mähdreschers.
- Fig. 7: zeigt ein Detail der Siebebene.

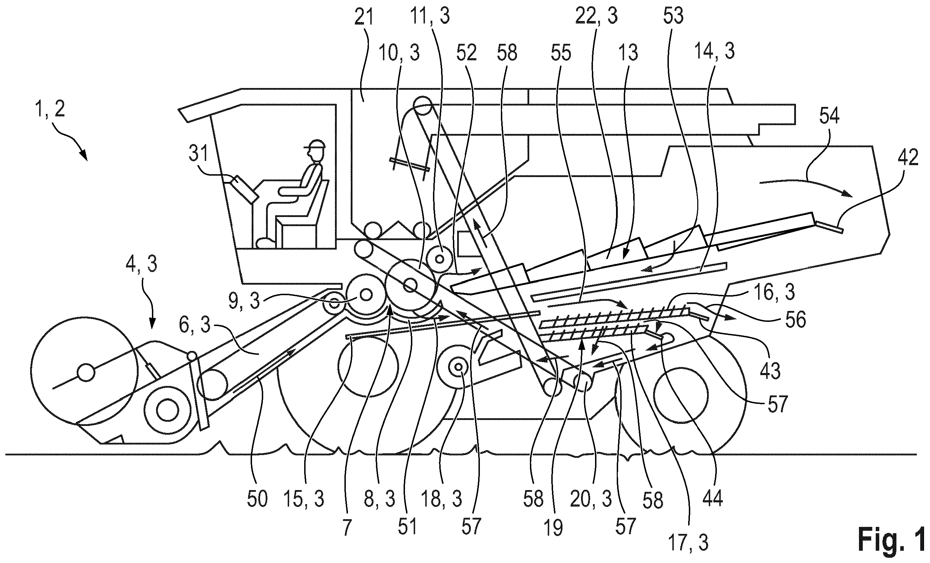

Figur 1 zeigt schematisch eine als Mähdrescher 1 ausgeführte selbstfahrende landwirtschaftliche Arbeitsmaschine 2. Der Mähdrescher 1 weist eine Vielzahl von Arbeitsorganen 3 zur Förderung und/oder Verarbeitung des Erntegutes (nicht dargestellt) auf.

Das Erntegut wird mittels eines Vorsatzgerätes 4 aufgenommen, und in einem zugeführten Erntegutstrom 50 mittels eines Schrägförderers 6 zum Dreschwerk 7 geführt. Das Dreschwerk 7 umfasst einen Dreschkorb 8, eine Beschleunigungstrommel 9, eine Dreschtrommel 10 und eine Umlenktrommel 11. Am Dreschkorb 8 erfolgt eine erste Abscheidung von freibeweglichen Körnern (nicht dargestellt) in Form eines ersten Erntegutstroms 51.

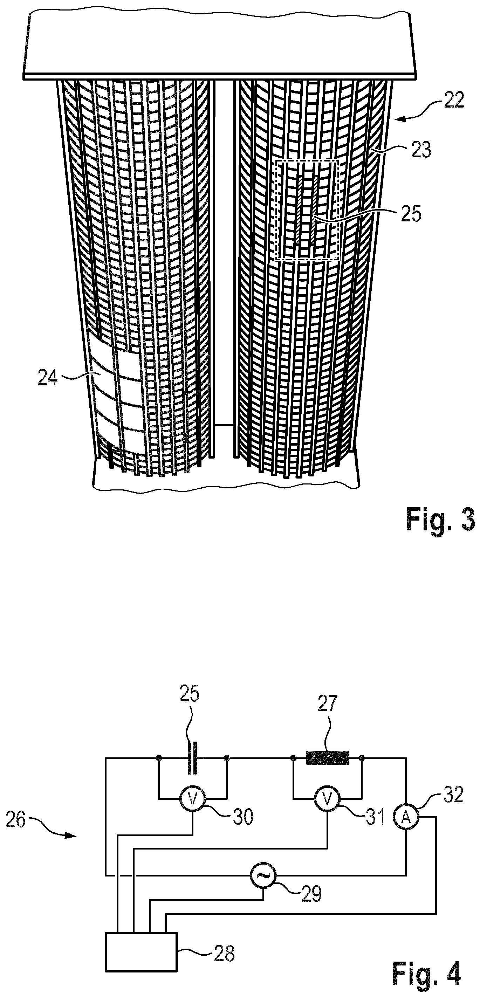

Nach Durchlaufen des Dreschwerks 7 wird ein aus diesem austretender zweiter Erntegutstrom 52, der Halmteile und noch nicht ausgedroschene Körner enthält, einer als Hordenschüttler 12 ausgeführten Trenneinheit 13 zugeführt. Die im zweiten Erntegutstrom 52 noch enthaltenen freibeweglichen Körner werden mittels des Hordenschüttler 12 in Form eines dritten Erntegutstroms 53 auf einen Rücklaufboden 14 und einen Vorbereitungsboden 15 abgeschieden. Der restliche vierte Erntegutstrom 54, vornehmlich bestehend aus Halmteilen, wird aus der Erntemaschine 2 herausgefördert. Der vierte Erntegutstrom 54 überquert dabei einen ersten Verlustkornzähler 42. Der Verlustkornzähler 42 ist ein Sensorsystem 26, wie es in Figur 4 dargestellt ist. Ein Kondensator, bevorzugt ein planarer Interdigitalkondensator, in auf einem flachen Oberfläche angebracht über die der vierte Erntegutstrom hinweg fließt. Das Sensorsystem erfasst die Elemente des Erntegutstromes und unterscheidet dabei zwischen Korn- und Nichtkornelementen.

Die Erfindung bezieht sich nicht nur auf Mähdrescher 1 mit einer als Hordenschüttler 12 ausgebildeten Trenneinheit 13. Sondern es liegt im Rahmen der Erfindung, dass es sich auch um einen Mähdrescher 1 mit Trennrotoren oder anderen Trenneinheiten 13 handeln kann.

Sowohl der aus dem Dreschkorb 8 als auch der aus dem Hordenschüttler 12 austretende, vornehmlich Körner enthaltende erste und dritte Erntegutstrom 51, 53 werden über den Rücklaufboden 14 und den Vorbereitungsboden 15 zu einem fünften Erntegutstrom 55 zusammengeführt und einer aus mehreren Siebebenen 16,17 und einem Gebläse 18 bestehenden Reinigungseinheit 19 zugeführt. Die Körner des fünften Erntegutstroms 55 werden hier gereinigt und Nicht-Kornbestandteile, wie beispielsweise Spreu- und Halmteile, in Form eines sechsten Erntegutstroms 56 abgetrennt und aus der Erntemaschine 2 herausgefördert. Der sechste Erntegutstrom 56 überquert dabei einen zweiten Verlustkornzähler 43. Der Verlustkornzähler 43 ist ein Sensorsystem 26, wie es in Figur 4 dargestellt ist. Die Funktionsweise ist identisch zum ersten Verlustkornzähler 42.

Der dargestellte Mähdrescher 1 weist zudem einen Überkehrschnecke 20 auf, über den ein nicht vollständig ausgedroschener siebter Erntegutstrom 57 dem Dreschwerk 7 erneut zugeführt werden kann. Der siebte Erntegutstrom 57 überquert bei seinem Weg zur Überkehrschnecke 20 einen Überkehr-Kornzähler 44. Der Überkehr-Kornzähler 44 ist ein Sensorsystem 26, wie es in Figur 4 dargestellt ist. Die Funktionsweise ist identisch zum ersten Verlustkornzähler 42.

Ein gereinigter, aus Körnern bestehender achter Erntegutstrom 58 wird einem Korntank 21 zugeführt. Die gezeigten Erntegutströme 50-58 sind nicht abschließend zu verstehen und hängen von der technischen Konfiguration der Erntemaschine 2 ab.

Der dargestellte Mähdrescher 1 weist an den siebartigen Elementen, also dem Dreschkorb 8, dem Schüttler 12 und den Siebebenen 16, 17 eine Vielzahl von Sensorsystemen auf. Die durch die siebartigen Elemente 8, 12, 16, 17 hindurchtretenden Elemente der Erntegutströme werden von den Sensorsystemen gezählt. Dabei unterscheiden die Sensorsysteme zwischen Körnen und Strohelemente.

Durch eine Vielzahl Sensorsystemen kann unterschieden werden an welchem siebartigen Element 8, 12, 16, 17 wie viele Körner abgeschieden werden und wie viel Stroh durch die siebartigen Elemente 8, 12, 16, 17 tritt. Daraus kann geschlossen werden wie effektiv die jeweiligen Arbeitsorgane 9, 10, 11, 12, 16, 17 arbeiten.

An jedem siebartigen Element sind eine Vielzahl an Sensorsystemen über die Fläche verteilt. So kann bspw. erkannt werden wo am Schüttler 12 wie viele Kornelemente und Strohelemente in den dritten Erntegutstrom 53 übergehen. Darauf kann erkannt werden ob der Schüttler gut eingestellt ist und die Einstellung ggf. geändert werden.

Die Zählungen der Sensorsysteme laufen in einer Kontrolleinheit 31 zusammen. Die Kontrolleinheit 31 zeigt die Zählungen dem Bediener an, sodass dieser die Einstellungen der Arbeitsorgane 3 anpassen kann. Alternativ kann die Kontrolleinheit 31 die Einstellungen selbsttätig vornehmen.

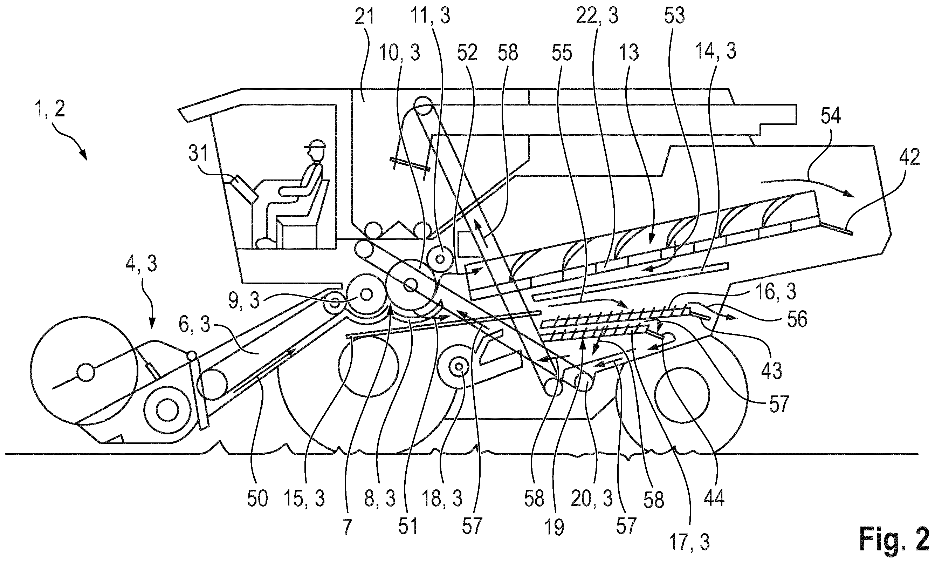

Figur 2 zeigt eine alternative Version eines Mähdreschers 1 mit einem Trennrotor 22. Im Folgenden werden nur die Unterschiede zu Figur 1 erläutert. Der Rotor 22 dient als Alternative zum Hordenschüttler 12 und nimmt den zweiten Erntegutstrom 52 auf. Die Außenseite des Rotors 22 weist eine Gitterstruktur 23 auf und ist damit ein siebartiges Element. Die Elemente des dritten Ertengutstromes 53 verlassen den Trennrotor durch die Gitterstruktur 23. Sensoren an der Gitterstruktur 23 zählen die Elemente des dritten Erntegutstromes 53. Die Sensoren unterscheiden dabei zwischen Kornelementen und Strohelemente.

Figur 3 zeigt einen Trennrotor 22 des Mähdreschers 1 aus Figur 2. Ein Trennrotor 22 ist ein Axialabscheider. In Figur 3 ist der Trennrotor 22 von unten gezeigt. Die Außenseite des Trennrotors 22 weist eine Gitterstruktur 23 auf. Die Öffnungen der Gitterstruktur 23 sind teilweise mit Klappen 24 verschließbar. Direkt an der Gitterstruktur 23 sind planare Kondensatoren 25 angebracht. Die Oberfläche der Kondensatoren 25 erstreckt sich senkrecht zur Außenseite des zylindrischen Trennrotors 22. Die Elemente des Erntegutstromes im Trennrotor 22 verlassen den Trennrotor 22 üblicherweise senkrecht zur Außenseite des Trennrotors 22. Die Oberflächennormale des Kondensators 25 ist damit im Wesentlichen senkrecht zur Bewegungsrichtung des Erntegutstromes ausgerichtet. Die planaren Kondensatoren 25 können auch auf der Oberfläche der Klappen 24 angebracht sein. Wenn die Klapppen 24 geöffnet sind, in die Oberflächennormale des Kondensators 25 im Wesentlichen senkrecht zur Bewegungsrichtung des Erntegutstromes ausgerichtet. Je nach Ausgestaltung des Sensorsystems kann auch das ganze Sensorsystem direkt an der Gitterstruktur 23 oder an den Klappen 24 angebracht werden.

Figur 4 zeigt ein Schema eines Sensorsystems 26 zur Erfassung von Elementes eines Erntegutstromes. Das Sensorsystem 25 umfasst einen Kondensator 25, ein induktives Bauelement 27, wie eine Spule, und eine Messeinrichtung 28. Die Messeinrichtung 28 regt den Schwingkreis aus Kondensator und Spule über eine Spannungsquelle 29 an und misst eine erste Spannung 30 über dem Kondensator 25, eine zweite Spannung 31 über der Spule 27 und/oder den Strom 32 durch den Schwingkreis. Es versteht sich, dass der Schwingkreis sowohl als Reihenschaltung als auch als Parallelschaltung ausgeführt sein kann.

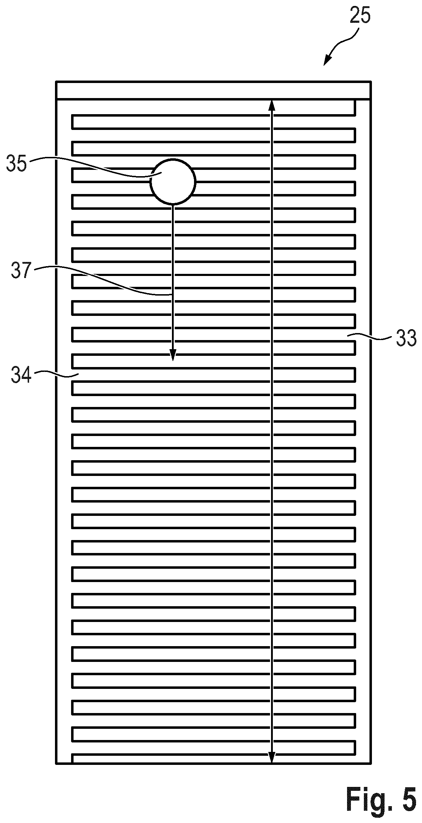

Figur 5 zeigt ein Schema eines Interdigitalkondensators 25. Der Interdigitalkondensator 25 weist zwei Elektroden 33, 34 auf. Die Elektroden 33, 34 weisen jeweils eine Vielzahl an fingerartigen Strukturen auf, wobei die fingerartigen Strukturen in einander verschränkt sind. Ein Element 35 aus dem Erntegutstrom beeinflusst die Kapazität des Interdigitalkondensators 25 unabhängig von seiner Position an der Oberfläche des Interdigitalkondensators 25. Das Element 35 des Erntegutstromes kann daher über die gesamte Länge 36 des Interdigitalkondensators 25 in der Bewegungsrichtung 37 des Erntegutstromes detektiert werden.

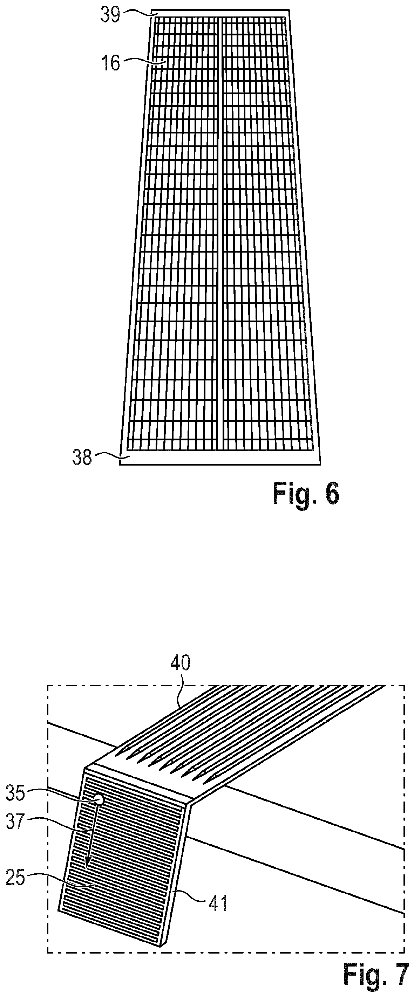

Figur 6 zeigt eine Siebebene 16 des Mähdreschers 1. Der fünfte Erntegutstrom 55 fällt von oben auf das vordere Ende 38 der Siebebene 16. Das Erntegut wird durch zyklische Bewegungen der Siebebene durch Wurfbewegungen an das hintere Ende 39 der Siebebene 16 befördert. Dabei fallen Elemente des Erntegutstromes durch die gitterartige Struktur des Siebelementes.

Figur 7 zeigt ein Detail der Siebebene 16 im Querschnitt. Die Siebebene 16 weist beweglich Elemente auf. Ein oberer Teil 40 des beweglichen Elementes kann von einer in der Ebene der Siebebene 16 in eine Position senkrecht zur Ebene der Siebebene gekippt werden. Je nach Anstellungswinkel des beweglichen Elements sind die Öffnungen der gitterartigen Strukur größer oder kleiner. Durch den Anstellungswinkel kann daher die Größe der Elemente des Erntegutes bestimmt werden, die durch die gitterartige Struktur hindurchtreten können. Ein unterer Teil 41 des beweglichen Elementes ist in einem festen Winkel mit dem oberen Teil des beweglichen Elementes verbunden. An dem unteren Teil 41 des beweglichen Elementes ist ein Kondensator 25 befestigt. Elemente 35 des Erntegutstromes, die durch die Öffnungen treten beeinflussen die Kapazität des Kondensators 25. Die Bewegungsrichtung 37 der Elemente ist dabei im Wesentlichen senkrecht zur Siebebene 16. Der Kondensator 25 ist Teil eines in Figur 4 gezeigten Sensorsystems 26. Die Änderung der Kapazität des Kondensators wird durch das Sensorsystem 26 gemessen. Aus der Größe der Änderung der Kapazität des Kondensators 25 kann auf die Permitivität des jeweiligen Elementes 35 geschlossen werden. Über die Permitivität können bspw. Körner von Strohelementen unterschieden werden.

Es versteht sich, dass jedes Sensorsystem 26 eine Vielzahl an Kondensatoren 25 umfassen kann. Durch kleinere Kondensatoren 25 können die Elemente des jeweiligen Erntegutstromes besser erfasst werden, da weniger Elemente während einer Messung gleichzeitig gemessen werden. Im Idealfall befindet sich bei jeder Zählung nur ein Element im Messbereich. Befinden sich während einer Messung mehrere Elemente im addiert sich der Einfluss der Elemente auf die Kapazität des Kondensators und die Anzahl und Art der Elemente muss entsprechend berechnet werden. Damit möglichst alle Elemente des jeweiligen Erntegutstromes erfasst werden, ist es vorteilhaft bei kleineren Kondensatoroberflächen die Messfrequenz höher zu wählen. Ebenso ist es vorteilhaft die Messfrequenz höher zu wählen, wenn die Bewegungsgeschwindigkeit des Erntegutstromes höher ist. Bei zu kleinen Messfrequenzen können sich Elemente des Erntegutstromes zwischen zwei Messungen über den Kondensator bewegen ohne vom Sensorsystem erfasst zu werden. Dem Hersteller der landwirtschaftlichen Erntemaschine sind die Größen der Kondensatoren und die Bewegungsgeschwindigkeiten der Erntegutströme bekannt, sodass er entsprechende Messfrequenzen vorbestimmen kann.

### Bezugszeichenliste

- 1: Mähdrescher
- 2: Landwirtschaftliche Arbeitsmaschine
- 3: Arbeitsorgan
- 4: Vorsatzgerät
- 50: Zugeführter Erntegutstrom
- 51: Erster Erntegutstrom
- 52: Zweiter Erntegutstrom
- 53: Dritter Erntegutstrom
- 54: Vierter Erntegutstrom
- 55: Fünfter Erntegutstrom
- 56: Sechster Erntegutstrom
- 57: Siebter Erntegutstrom
- 58: Achter Erntegutstrom
- 6: Schrägförderer
- 7: Dreschwerk
- 8: Dreschkorb
- 9: Beschleunigungstrommel
- 10: Dreschtrommel
- 11: Umlenktrommel
- 12: Hordenschüttler
- 13: Trenneinheit
- 14: Rücklaufboden
- 15: Vorbereitungsboden
- 16: Siebebene
- 17: Siebebene
- 18: Gebläse
- 19: Reinigungseinheit
- 20: Überkehrschnecke
- 21: Korntank
- 22: Rotor
- 23: Gitterstruktur
- 24: Klappen
- 25: Kondensator
- 26: Sensorsystem
- 27: Spule
- 28: Messeinrichtung
- 29: Spannungsquelle
- 30: Erste Spannug
- 31: Zweite Spannung
- 32: Strom
- 33: Elektrode
- 34: Elektrode
- 35: Element eines Erntegutstromes
- 36: Länge
- 37: Bewegungsrichtung
- 38: Vorderes Ende der Siebebene
- 39: Hinteres Ende der Siebebene
- 40: Oberer Teil des beweglichen Elementes
- 41: Unterer Teil des beweglichen Elementes
- 42: Erster Verlustkornzähler
- 43: Zweiter Verlustkornzähler
- 44: Überkehr-Kornzähler

## Patentansprüche

1. Mähdrescher (1) mit einem siebartigen Element (8, 12, 16, 17) und einem Sensorsystem (26),
wobei das Sensorsystem (26) einen Schwingkreis und einer Messeinrichtung (28) umfasst, wobei
der Schwingkreis aus zumindest einem kapazitiven Bauelement (25) mit einer Kapazität und einem induktiven Bauelement (27) besteht,
wobei das kapazitive Bauelement (25) in unmittelbarer Nähe des siebartigen Elementes (8, 12, 16, 17) angebracht ist,
wobei das siebartige Element (8, 12, 16, 17) durchlaufende Elemente (35) eines Erntegutstromes (50, 51, 52, 53, 54, 55, 56, 57, 58) das kapazitive Bauelement (25) passieren und zumindest temporär die Kapazität des kapazitiven Bauelementes (25) verändern,
wobei die Messeinrichtung (28) die Resonanzfrequenz des Schwingkreises bestimmt,
wobei das kapazitive Element (25) in Bewegungsrichtung (37) des Erntegutstromes (50, 51, 52, 53, 54, 55, 56, 57, 58) hinter dem siebartigen Element (8, 12, 16, 17) angeordnet ist,
wobei das kapazitive Bauelement (25) als planarer Kondensator (25) ausgebildet ist, nämlich als Interdigitalkondensator (25) ausgestaltet ist.

2. Mähdrescher nach Anspruch 1, **dadurch gekennzeichnet, dass** das siebartige Element (8, 12, 16, 17) ein Dreschkorb (8), ein Rotor, ein Schüttler (12) oder ein Reinigungssieb (16, 17) ist.

3. Mähdrescher nach einem der Ansprüche 1 oder 2, **dadurch gekennzeichnet, dass** die Oberflächennormale des Kondensators (25) im Wesentlichen senkrecht zur Bewegungsrichtung (37) des Erntegutstromes (50, 51, 52, 53, 54, 55, 56, 57, 58) ausgerichtet ist.

4. Mähdrescher nach einem der vorhergehenden Ansprüche, **dadurch gekennzeichnet, dass** das kapazitive Bauelement (25) auf einer Oberfläche des siebartigen Elementes (8, 12, 16, 17) angebracht ist.

5. Mähdrescher nach einem der vorhergehenden Ansprüche, **dadurch gekennzeichnet, dass** die Messeinrichtung (28) die Resonanzfrequenz mit einer vorbestimmten Messfrequenz bestimmt.

6. Mähdrescher nach Anspruch 5, **dadurch gekennzeichnet, dass** die Resonanzfrequenz größer ist als das Zehnfache der Messfrequenz.

7. Mähdrescher nach Anspruch 5, **dadurch gekennzeichnet, dass** die Messfrequenz multipliziert mit der Länge (36) des kapazitiven Bauelementes (25) in Bewegungsrichtung (36) des Erntegutstromes (50, 51, 52, 53, 54, 55, 56, 57, 58) größer ist als 2m/s, bevorzugt größer 10m/s, besonders bevorzugt 25m/s ist.

## Claims

1. Combine harvester (1) with a sieve-like element (8, 12, 16, 17) and a sensor system (26),
wherein the sensor system (26) comprises an oscillating circuit and a measuring device (28), wherein
the oscillating circuit consists of at least a capacitive component (25) with a capacitance and an inductive component (27),
wherein the capacitive component (25) is attached in the immediate vicinity of the sieve-like element (8, 12, 16, 17),
wherein elements (35) of a crop flow (50, 51, 52, 53, 54, 55, 56, 57, 58) that pass through the sieve-like element (8, 12, 16, 17) pass the capacitive component (25) and at least temporarily change the capacitance of the capacitive component (25),
wherein the measuring device (28) determines the resonant frequency of the oscillating circuit,
wherein the capacitive element (25) is arranged downstream of the sieve-like element (8, 12, 16, 17) in the direction of movement (37) of the crop flow (50, 51, 52, 53, 54, 55, 56, 57, 58),
wherein the capacitive component (25) is formed as a planar capacitor (25), namely is designed as an interdigital capacitor (25).

2. Combine harvester according to Claim 1, **characterized in that** the sieve-like element (8, 12, 16, 17) is a threshing concave (8), a rotor, a walker (12) or a cleaning sieve (16, 17).

3. Combine harvester according to either of Claims 1 and 2, **characterized in that** the surface normal of the capacitor (25) is oriented substantially perpendicularly to the direction of movement (37) of the crop flow (50, 51, 52, 53, 54, 55, 56, 57, 58).

4. Combine harvester according to any of the preceding claims, **characterized in that** the capacitive component (25) is attached to a surface of the sieve-like element (8, 12, 16, 17).

5. Combine harvester according to any of the preceding claims, **characterized in that** the measuring device (28) determines the resonant frequency with a predetermined measurement frequency.

6. Combine harvester according to Claim 5, **characterized in that** the resonant frequency is greater than ten times the measurement frequency.

7. Combine harvester according to Claim 5, **characterized in that** the measurement frequency multiplied by the length (36) of the capacitive component (25) in the direction of movement (36) of the crop flow (50, 51, 52, 53, 54, 55, 56, 57, 58) is greater than 2 m/s, preferably greater than 10 m/s, particularly preferably 25 m/s.

## Revendications

1. Moissonneuse-batteuse (1) dotée d'un élément de type grille (8, 12, 16, 17) et d'un système de capteur (26),
dans laquelle le système de capteur (26) comprend un circuit oscillant et un dispositif de mesure (28), où
le circuit oscillant est constitué d'au moins un composant capacitif (25) avec une capacité et un composant inductif (27),
le composant capacitif (25) étant installé à proximité immédiate de l'élément de type grille (8, 12, 16, 17),
dans laquelle des éléments (35) d'un flux de récolte (50, 51, 52, 53, 54, 55, 56, 57, 58) qui traversent l'élément de type grille (8, 12, 16, 17) passent devant le composant capacitif (25) et modifient au moins temporairement la capacité du composant capacitif (25),
le dispositif de mesure (28) déterminant la fréquence de résonance du circuit oscillant,
l'élément capacitif (25) étant disposé après l'élément de type grille (8, 12, 16, 17) dans le sens de déplacement (37) du flux de récolte (50, 51, 52, 53, 54, 55, 56, 57, 58),
le composant capacitif (25) étant réalisé sous forme de condensateur (25) plan, à savoir comme condensateur interdigité (25).

2. Moissonneuse-batteuse selon la revendication 1, **caractérisée en ce que** l'élément de type grille (8, 12, 16, 17) est un contre-batteur (8), un rotor, un secoueur (12) ou une grille de nettoyage (16, 17).

3. Moissonneuse-batteuse selon une des revendications 1 ou 2, **caractérisée en ce que** la normale à la surface du condensateur (25) est orientée de manière sensiblement perpendiculaire au sens de déplacement (37) du flux de récolte (50, 51, 52, 53, 54, 55, 56, 57, 58).

4. Moissonneuse-batteuse selon une des revendications précédentes, **caractérisée en ce que** le composant capacitif (25) est disposé sur une surface de l'élément de type grille (8, 12, 16, 17).

5. Moissonneuse-batteuse selon une des revendications précédentes, **caractérisée en ce que** le dispositif de mesure (28) détermine la fréquence de résonance avec une fréquence de mesure prédéfinie.

6. Moissonneuse-batteuse selon la revendication 5, **caractérisée en ce que** la fréquence de résonance est supérieure à dix fois la fréquence de mesure.

7. Moissonneuse-batteuse selon la revendication 5, **caractérisée en ce que** la fréquence de mesure multipliée avec la longueur (36) du composant capacitif (25), dans le sens de déplacement du flux de récolte (50, 51, 52, 53, 54, 55, 56, 57, 58), est supérieure à 2m/s, de préférence supérieure à 10 m/s, et est de manière particulièrement avantageuse de 25m/s.
